# EUROPEAN PATENT APPLICATION

(11) **EP 1 983 079 A1**
(43) Date of publication of application: **22.10.2008**
(21) Application number: 07106347.3
(22) Date of filing: 17.04.2007
(51) Int. Cl.: C25D 3/66, C25D 5/18, H01L 51/00, H01L 51/52, H01L 51/10, H01L 51/44

(54) **Barrier layer and method for making the same**

(71) Applicant: Nederlandse Organisatie voor Toegepast-Natuurwetenschappelijk Onderzoek TNO, 2628 VK Delft (NL)
(72) Inventor: Van Mol, Antonius Maria Bernardus, 5658 HC Eindhoven (NL); Schoo, Harmannus Franciscus Maria, 5521 PR Eersel (NL); Bressera, Petrus Marinus Martinus Cornelus, 8032 MZ Zwolle (NL); Van Erkel, Joost, 7314 CN Apeldoorn (NL); Koetse, Marinus Marc, 5644 EE Eindhoven (NL)
(74) Representative: van Loon, C.J.J.

(57) **Abstract**

The invention relates to a method for manufacturing an article comprising a barrier layer, the method comprising
- providing an metallic or metalloid layer to a surface of a substrate by electro-deposition, using a plating liquid comprising an ionic liquid and metal ions or metalloid ions, which metal ions or metalloid ions are reduced and deposited to form the metallic or metalloid layer during the electro-eleposition; and
- preferably at least partially oxidising the metallic or metalloid layer.

## Description

The invention relates to a method for providing an article with a barrier layer, and to an article obtainable by such a method.

Barrier films, having a low permeability for oxygen and/or water, are used in various applications to protect a product from a detrimental effect of oxygen and/or water. For example, in food processing packaging foils may be provided with one or more thin layers of an inorganic material to reduce permeation of water and/or oxygen through the foil.

Protection against oxygen and/or water (moisture) is very important in organic electronic devices, such as opto-electronic devices, such as organic light emitting diodes (OLED's) or organic photo-voltaic cells (OPV). Classically, such devices are encapsulated using metal or glass sheet as a substrate (on which the functional layers are applied) and a metal or glass lid. However, disadvantages of such design include limitations with respect to the geometry (as the minimum thickness will be relatively high) and limited flexibility of the device, whereas for actuators and/or opto-electronic devices a low thickness and/or a high flexibility can be desirable. For protection against oxygen and/or water, the device may be sealed with a protective cap that is substantially impermeable to oxygen and/or water. Such cap adds to the volume of the device. Further, it is a challenge to adhere the cap sufficiently well, as adhesives suitable for gluing the cap may be permeable to water and /or oxygen. In particular, with respect to opto-electronics, reduced transparency may be a drawback of using classical encapsulation.

It has been proposed to provide an article, in particular an opto-electronic device, with a thin film barrier coating of an inorganic material in order to provide protection against oxygen and/or water, whilst maintaining flexibility.

For instance inorganic barrier coatings, such as a silicon carbide, silicon nitride or silicon oxide coating, can be applied in a sufficiently thin layer, to allow the device to remain sufficiently flexible. However, layers of such barrier material generally have defects in the layer structure, known as pinholes. These pinholes may give rise to increased permeability for oxygen and/or water, the presence of which may have a deteriorating effect on the functioning of the material covered by the coating. In particular, pinholes are an important cause of the occurrence of black spots in the device, leading to poorer quality of the device, e.g. reduced light intensity in case of a LED, or loss of image resolution in case the device is a device to display an image.

WO 2004/079781 relates to an organic LED comprising a silicon based barrier coating, such as a silicon carbide. The barrier coating is typically applied using a vapour deposition technique. Such a technology is expensive, complicated, and not generally applicable for flexible devices, such as organo-electronic devices, in particular such foil-shaped devices, or at least such technology is impractical to be used on an industrial scale.

Multiple barrier layers may be applied to provide a barrier stack. Thus, the pinholes in a specific layer of the stack may at least partially be covered by the adjacent layer(s), which may have some beneficial effect on the permeability. However, pin hole growth may still result in increased permeability, after a relatively short time, i.e. resulting in a short lag-time.

WO 2005/015655 relates to a method for applying a thin film barrier stack to a device with microstructures, for instance an OLED, wherein organic layers are used as intermediate layers between two inorganic layers, in order to prevent continued growth of pinholes. In accordance with this publication, the barrier layer is applied by a vacuum deposition technique, which is expensive, complicated, and not generally applicable for flexible devices, such as organic electronic devices, or at least such technology is impractical to be used on an industrial scale. Moreover the need to manufacture a stack of inorganic layers and organic layers is a further factor complicating the manufacture of the product.

WO 2005/006441 relates to an encapsulation structure for a display device, comprising at least one dielectric sealing structure, such as a silicon nitride or aluminium oxide layer, and a stabilisation layer to stabilise and protect the sealing structure. The present inventors contemplate that the number of pinholes may be relatively high, in particular in case the nitride has been deposited at a relatively low temperature, such as a temperature which is not detrimental to the functioning of an organic electro-active material in an organic electronic device, in particular a temperature below about 100 °C or below about 50 °C, more in particular a temperature at or near room temperature (25) °C. In order to cover the pinholes, WO 2005/006441 proposes the use of a second inorganic material, such as a specific oxide layer, which is stated not to provide a significant diffusion barrier for the oxygen/water, as the nitride. This publication also refers to the use of a vapour deposition technique for applying the layers.

It is an object of the present invention to provide a novel method for preparing an organic electronic device, which may serve as an alternative to known methods.

It is further an object to provide a novel method for preparing an organic electronic device which is relatively simple to be carried out on a industrial scale, in particular, continuously.

It is further an object to provide a novel method for manufacturing an organic electronic device with a low-risk of black spot formation, in particular, a reduced tendency of black spot formation.

It is further an object to provide a novel device provided with a barrier layer, in particular a novel organic electronic device.

One or more other objects which may be met in accordance with the invention will follow from the remainder of the description and/or the claims.

It has now been found that one or more objects are met by providing an article with a barrier layer in a specific way.

Accordingly, the present invention relates to a method for manufacturing an article comprising a barrier layer, the method comprising
- providing an metallic or metalloid layer to a surface of a substrate by electro-deposition, using a plating liquid comprising an ionic liquid and metal ions or metalloid ions, which metal ions or metalloid ions are reduced and deposited to form the metallic or metalloid layer; and
- preferably at least partially oxidising the metallic or metalloid layer.
In particular for providing a transparent barrier layer, it is preferred that the metallic or metalloid layer is oxidised to provide a transparent layer (such as a transparent oxide). Thus, in case of an opto-electronic device, a transparent (oxide) layer may be provided at least at an area of the device from which light is to be emitted (in case of a LED) or through which light is to pass into the device.

The term "or" as used herein means "and/or" unless specified other wise.

The term "a" or "an" as used herein means "at least one" unless specified other wise.

When referring to a moiety (*e.g.* a compound, an ion, an additive etc.) in singular, the plural is meant to be included. Thus, when referring to a specific moiety, *e.g.* "ion", this means "at least one" of that moiety, *e.g.* "at least one ion", unless specified otherwise.

The term "electro-active" is used herein for a material which is capable of converting a non-electric form of energy into electric energy or *vice versa.* Thus an electro-active material may be capable of converting mechanical energy or electromagnetic radiation (such as UV, visible light or IR) into electrical energy or transferring electrical energy into mechanical energy or electromagnetic radiation. In particular an electro-active material is capable of acting as a (semi-) conductor for electrical energy.

In principle, a method of the invention may be used to provide any substrate with a barrier layer. In particular in case the substrate is not sufficiently conductive for effective electro-deposition, the surface to be treated may be made more conductive by applying a seed layer of a conductive material, in particular a metal, *e.g*. gold or aluminium. Suitable techniques are generally known in the art and include (seed-layer) printing, coating and the like.

A method of the invention may in particular be used for the manufacture of a thin article, such as a foil-shaped article. The article may in particular be selected from the group of foils, sheets, films, plates, strips and other articles of which the size in one dimension (thickness) is considerably less than the size in the other dimensions (length, width), *e.g*. at least 10 times less, at least 100 times less or at least 1000 times less. For instance foils may have a thickness of 10-200 µm and/or a width of 1 cm or more, *e.g*. up to 1, 2, 5 or 10 m. The length may be even higher.

A method of the invention is also highly suitable for an article having a complex geometry, such as having one or more convex and/or one or more concave surfaces.

In a preferred method, the article is selected from the group of organic diodes, such as organic LED's, organic photo-voltaic cells; organic actuators for converting mechanical energy to electrical energy or vice versa; organic electrical circuits, organic transistors, organic solar cells, other organic electronic devices; steel sheets; and packaging foils, such as aluminium packaging foils or plastic packaging foils.

Organic electronic devices, as used herein are devices, usually comprising, an a first electrode (usually an anode), a second electrode (usually a cathode), and an electro-active layer, usually situated between the electrodes, of which at least an electro-active layer comprises a electro-active organic compound, for instance an electro-active polymer. The compound may be photo-active, capable of converting electrical energy into mechanical energy and/or capable of converting mechanical energy into electrical energy.

The electrodes and electro-active layer comprising the electro-active organic compound, and an electrode are usually applied on a substrate. The barrier layer is usually at least applied to cover the assembly of electrodes and electro-active compound, such that these are essentially sealed (encapsulated) between the substrate and the barrier layer. Preferably, a barrier layer is also provided between the substrate and the assembly of electrodes and electro-active compound. It is particularly preferred that at least a layer which should be transparent, is oxidised to form a transparent layer.

One or more other layers may be present, such as an (organic) conducting layer (also referred to a buffer layer), between an electrode, in particular cathode, and organic electro-active material. Suitable conducting layers are for instance, poly(ethylene dioxythiophene) doped with poly(sodium styrenesulphonate) (PEDOT), polyaniline (PANI) or poly(styrenesulphonate) (PSS), or a combination thereof such as PEDOT+PSS.

One or more further functional layers for the electronic device, such as one or more planarisation layers, etcetera, may be applied. The layers may be carried out in a manner known *per se, e.g.* as described in US 2002/0113548, WO 2005/001945, WO 2005/015173, WO 03/026011, WO03/022581 or WO 02/082561, with the proviso that at least one of the electrodes, preferably at least the cathode, is applied by electro-deposition in accordance with the present invention.

In an embodiment, the electro-active device is an organic photodiode, such as a polymeric, photodiode. An organic/polymeric photodiode is herein understood to mean a photodiode of which an active layer comprises at least one (semi)conductive organic compound (including a composition thereof), and of at least one (semi)conductive organic polymer (including a composition thereof), respectively. The photodiode preferably comprises an electron-donating organic material (p-type material) and an electron-accepting organic material (n-type material). The photodiode can comprise as active layer a material (such as a conductive polymer) which exhibits photoconduction when it is under an electric potential.

The photodiode may be a photovoltaic cell, which, without an electric potential present, exhibits photoconduction and is capable of converting photon energy into electric energy. In such a cell, as electron-donating material and preferably also as electron-accepting material, an organic compound, more preferably an organic polymer, is present. Electron-donating and electron-accepting material can be mixed or be present in separate layers.

In an embodiment, the electro-active material is a polymer selected from the group of polyarylene compounds, poly(paraphenylene vinylene) compounds, polyfluorene compounds, polyacetylene compounds, polythiophene compounds, polypyrroles, polyanilines, including derivatives of said polymers (in particular alkyl, aryl and alkoxy derivatives), copolymers of said polymers and said polymers which have been derivatized with a dye In a photovoltaic cell, such polymers have been found very suitable as electron-donating compound. The photoactive layer which comprises a fullerene and/or a fullerene derivative, preferably PCBM, as electron-accepting compound.

In the case of an organic light emitting diode (OLED), the electro-active layer comprises an electroluminescent compound. An organic light emitting diode (hereinafter OLED) is herein understood to mean a light emitting diode whose photoactive layer consists at least substantially of at least one (semi)conductive electroluminescent organic compound or composition. A polymeric light emitting diode (hereinafter called PLED) is herein understood to mean a light emitting diode whose photoactive layer consists at least substantially of at least one (semi)conductive electroluminescent organic polymer (including polymer mixtures) or at least one (semi)conductive organic polymer (including polymer mixtures) and at least one other organic compound (for instance a single compound), which is electroluminescent.

Preferred electroluminescent compounds are polyarylenes, more preferably poly(paraphenylene vinylene) compounds (PPV compounds), polyacetylenes, polyanilines, polythiophenes, polyfluorenes, polyvinylcarbazoles, polyphenylene compounds polyfluorene compounds polypyrroles, polyanilines, including derivatives of these polymers (in particular alkyl, aryl and alkoxy derivatives), copolymers of these polymers and mixtures thereof.

Besides a polymer (which term as used herein includes "oligome") a non-polymeric electroluminescent compound may be used, such as a non-polymeric electroluminescent dye. Examples of such compounds are monomers and other non-polymerized molecules with conjugated bonds. Often, such compounds have a relatively low molecular weight compared with polymers, for instance a molecular weight of 100-20,000 g/mol.

With regard to the non-polymeric dyes, *inter alia ,* a compound according to Formula 1 may be used. 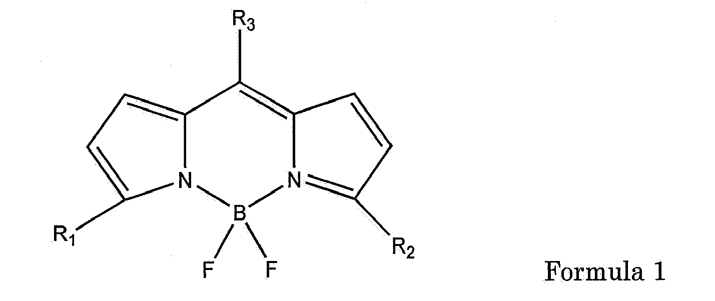 wherein each R₁, R₂, R₃ and R₄ are preferably each selected independently from the group of:
- H
- branched and unbranched alkyl groups of the formula -CₐH₂ₐ₊₁,
- branched and unbranched alkoxy groups of the formula -O-CₐH₂ₐ₊₁,
- aryl groups (optionally substituted with one or more alkyl groups and/or one or more alkoxy alkyl groups, preferably of the formula -CₐH₂ₐ₊₁, and -O-CₐH₂ₐ₊₁, respectively, as described above), preferably aryl groups having 6 to 12 carbon atoms in the ring structure
- C≡N

Herein "a" is preferably chosen in the range of from 1 to 20 and more preferably in the range of 2-10.

In a preferred embodiment, the OLED has at least two maxima. Light of a wavelength on or near one maximum can then serve, for instance, as a reference signal, and light of a wavelength at another maximum can then serve as detection signal. An OLED with more than one maximum can be provided for in that the OLED contains at least one electroluminescent active layer which comprises at least two different electroluminescent functionalities. Thus, for instance, the photoactive layer can contain a mixture of two different electroluminescent compounds. Examples include mixtures of the polymers mentioned herein, mixtures of the polymers mentioned herein with other electroluminescent compounds, for instance single conjugated compounds, and copolymers with different electroluminescent segments. Suitable examples thereof are described in WO 2005/001945, of which the contents with respect to the suitable electroluminescent compounds are incorporated herein by reference, in particular the part from page 10 line 10 to page 14, line 17.

In an embodiment, the electronic device is an actuator for converting between electrical and mechanical energy. Suitable examples thereof are *e.g.* described in the yet to be published European patent application 06076435.4 and in the yet to be published European patent application 06075808.3. The actuator may in particular comprise at least one polymer selected from the group of polyvinyl chlorides, polysaccharides, aromatic urethanes, aromatic urethane acrylates, (alkyl)acrylates, (alkyl)methacrylates, acrylonitrile polymers, polysaccharide derivatives (such as starch acetate, cellulose (tri)acetate), polyethers, polyvinylpyrrolidone, polyethyloxazoline and polyvinylidene fluoride.

In an embodiment, the actuator comprises an electro-active polymer which comprises aromatic moieties in the chain and flexible moieties in the chain, the polymer further comprising side groups bound to the chain, which side groups are selected from the group consisting of polar side groups and side groups comprising an aromatic moiety. Said flexible moieties of the polymer may in particular be selected from the group of (cyclo)aliphatic ether moieties, (cyclo)aliphatic ester moieties, (cyclo)aliphatic thioether moieties and (cyclo)aliphatic thioester moieties. Said aromatic moieties in the chain and - when present - in the side groups may in particular be selected from unsubstituted and substituted aromatic moieties having 6-20 carbon atoms; and/or the side groups may comprise a moiety selected from the group consisting of -OH, -CN, -NH₂, -NO₂ , aryloxy , phenyl, halogens, -COOH, NHR, NRR, -(CO)(NH₂), -(CO)(NHR) and -(CO)(NRR), wherein each R is the same or a different C1-C6 substituted or unsubstituted alkyl group.

In an embodiment, the actuator comprises an electro-active polyurethane-(meth)acrylate copolymer comprising aromatic urethane units and (alkyl)acrylate units, wherein preferably
at least part of (alkyl)acrylate units are based on a monomer represented by formula II 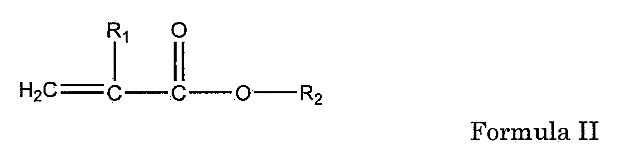 wherein
R₁ is hydrogen, an optionally substituted alkyl (in particular methyl) or a polar moiety;
R₂ is a polar moiety, an aromatic moiety (in particular a moiety comprising a phenyl), an optionally substituted alkyl or hydrogen;
provided that at least one or R₁ and R₂ is a polar moiety or an aromatic moiety; and/or wherein preferably at least part of the aromatic moieties in the chain are selected from the group of toluenediisocyanates and methylene diphenyl isocyanate.

Electrochemical deposition (also called electro-deposition or electroplating) of metals and metalloids, including alloys thereof, involves the reduction of ions from an electrolyte solution. The technique is well-known for deposition of various metals and metalloids. In electro-deposition the substrate is placed in a suitable electrolyte containing the ions of the metal or metalloid to be deposited. The substrate must have an electron conductive layer which forms the cathode which is connected to the negative terminal of a power supply. The positive terminal is connected to a suitable anode. The thickness of the deposited layer is a function of the number of electrons (charge) used in the electro-deposition process.

Surprisingly, electrodeposition can be used to provide a metallic or metalloid layer which - optionally after at least partial oxidation- forms a passivating barrier layer, which is capable of protecting the material provided with the barrier layer against oxygen, another gas, water and/or another liquid

A method of the invention can be employed to provide flexible articles, although rigid articles can also be made.

In particular, the invention allows providing a barrier layer with a permeability to water of less than 10⁻³ g water/m²/day, less than 10⁻⁴ g water/m²/day, less than 10⁻⁵ g water/m²/day or less than 10⁻⁶ g water/m²/day. The permeability may be determined as described in US 2006/147346.

In particular, the invention the barrier layer may have a low pinhole density, more in particular of less than 10⁶ pin holes per m² or less than of less than 10⁵ pin holes per m² (as determinable by scanning electron microscopy) a uniform thickness and/or a highly continuous coverage of the underlying surface.

Further, it is surprisingly possible to use electro-deposition to provide a inorganic barrier layer on an organic electronic device, without an unacceptable detrimental effect on the organic electro-active material, due adverse electrochemical processes which one may expect to take place during electro-deposition. A low pinhole density in such a device is in particular advantageous with respect to protecting the electro-active material(s) against oxygen and/or water and/or with respect to a low tendency of black spot formation.

A method of the invention may advantageously be employed under mild conditions, such at a relatively low temperature, which allows an electrode to be applied to a temperature sensitive material.

A method of the invention does not need to be carried out in a vacuum. The electro-deposition may in particular suitably be carried out in atmosphere of an inert gas. Examples of inert gases are nitrogen and noble gases (such as helium, neon, argon), including mixtures of nitrogen and one/or more noble gases.

Moreover, the method generally does not require to be operated by highly skilled personnel. It can be carried out in a relatively simple manner. In particular, a method of the invention may be carried out using relatively simple equipment, without needing a high investment, in particular compared to vacuum deposition technologies.

An advantage of a method according to the present invention is that an electrode can be applied onto a large surface by means of, for instance, a roll-to-roll deposition process. Such process allows which the method to be carried out in a continuous manner, which is advantageous, in particular, for large scale production. A roll-to-roll process is in particular suitable in case the substrate is a foil, a film or the like.

Electrochemical deposition (also called electro-deposition or electroplating) of metals and metalloids, including alloys thereof, involves the reduction of ions from an electrolyte solution. The technique is well-known for deposition of various metals and metalloids. In electro-deposition the substrate is placed in a suitable electrolyte containing the ions of the metal or metalloid to be deposited. The substrate must have an electron conductive layer which forms the cathode which is connected to the negative terminal of a power supply. The positive terminal is connected to a suitable anode. The thickness of the deposited layer is a function of the number of electrons (charge) used in the electro-deposition process.

Electro-deposition from aqueous solutions is only possible for providing a layer of a metal or metalloid having a sufficiently high standard potential (also known as Nernst potential). The standard potential of the metal or metalloid should be higher than the standard potential of water to hydrogen, or the kinetic for the reduction of water to hydrogen at the surface of the metal or metalloid should be so slow that the metal can be plated even if its standard standard potential is below 0 Volt. For instance the noble metals and copper are examples of the first category, while zinc, chromium and cadmium are within the second category of metals that can be plated from an aqueous solution.

However, an aqueous solution is in general not suitable or at least not practical for deposition of a metal or metalloid with a low standard potential, e.g., an alkaline earth metal (such as barium or calcium) or aluminium. The invention allows the use of a non-aqueous system, and thus also allows the use of electro- deposition for providing an electrode comprising one or more of such metals. For providing a barrier layer it is highly preferred to deposit the layer under essentially water-free conditions in order to achieve an advantageously low permeability for water and/or a gas and thus provide a layer with a particularly good barrier function.

Prior to the plating, the material upon which the electrode is to be formed may be pre-treated in a manner known in the art for electro-plating. In particular contaminants and/or films may be removed from the substrate. The pre-treatment may in particular comprise a chemical cleaning step, such as an electro-chemical cleaning step and or a physical cleaning step. Suitable pre-treatment steps are known in the art, and are, *e.g,* described in Dexter D. Snyder "Preparation for Deposition", chapter 23 in M. Schlesinger, M. Paunovic (eds), "Modern Electroplating", Electrochemical Society Series, 4th Edition, 2000, John Wiley & Sons, New York.

In case the surface of a substrate whereupon the barrier layer is to be provided, as such, is not sufficiently electrically conductive to be used in the electrodeposition process, a seed layer of a conductive material, such as a metal, e.g. gold or aluminium, may be applied prior to the electrodeposition. Suitable methods for providing such layer are generally known in the art and include printing and coating.

The voltage/current during the electro-deposition process may be performed at galvanostatic control (current control), potentiostatic (potential control, using the potential difference over the substrate and a reference electrode, or at cell voltage control (*i.e.* wherein the potential over the substrate and anode (counter electrode) is controlled.

Parameters that can be controlled to adjust one or more properties of the formed layer include cell voltage, cathode potential, and current conditions. More specifically, by choosing the duration of the electro-deposition and total charge (coulombs) applied for the duration of the electro-deposition, and in particular by choosing the applied current and/or potential, one or more properties can be influenced.

In an embodiment, the electro-deposition is accomplished using an essentially constant current, an essentially constant potential over the material upon which the metal or metalloid is deposited and a reference electrode, or a constant cell voltage.

However, it may be advantageous with respect to providing a barrier layer with an improved property, such as improved smoothness, improved impermeability (to water and/or another gaseous, vaporous or liquid component), and/or homogeneity, to change current and/or potential a plurality of times between at least one first value (A) and at least one second value different from said first value (B).

It is observed that in a method of the invention it is possible to first apply value A and thereafter value B or *vice versa.*

Typically, at least one of the values A respectively B is equal to or higher than the standard potential of the metal/metalloid ion which is to be reduced and deposited to form the electrode.

Thus, the potential and/or current may changed from
A) a potential respectively current being sufficient to cause reduction of the metal ions and/or metalloid ions (to a non-ionic state) - *i.e* a reducing potential/current - to
B) a potential respectively current being insufficient to cause reduction of the metal ions and/or metalloid ions, *i.e.* a non-reducing potential/current, which non-reducing potential/current may be an oxidising potential/current.

It is also possible to change the potential and/or current from
A) a potential having a high absolute value sufficient to cause reduction of the metal ions or metalloid ions, respectively a current through the substrate having a high absolute value sufficient to cause reduction of the metal ions or metalloid ions, to
B) a potential having a low absolute value, yet sufficient to cause the growth of nuclei comprising the metal or metalloid, respectively a current through the substrate having a low absolute value, yet sufficient to cause the growth of nuclei comprising the metal or metalloid.

A suitable potential/ current for step A respectively B is dependent upon the metal ions and/or metalloid ions from which the layer is formed, the material upon which the layer is formed and conditions such as the temperature.

A non-reducing and a reducing potential respectively current, can be routinely determined based on the standard potential of the specific metal or metalloid, optionally in combination with some routine experimentation.

A non-reducing potential/current may be an oxidising potential/current, i.e. a potential/current sufficient to cause part of the deposited metal/metalloid to be oxidised. An oxidising potential/current may be useful to etch or polish the surface of the deposited metal/metalloid. This may be beneficial to a property of the barrier layer.

By selecting the frequency by which the current/potential is changed, duration of the steps A respectively B, value of (absolute maximum of) the current/potential in steps A respectively B and/or slope by which the voltage/current is changed, one or more properties of the barrier layer to be formed may be influenced.

A non-reducing voltage/current (in step B) may be 0. Accordingly, the cell may be let at the open cell voltage, or at the rest potential for a period of time.

A non-reducing voltage/current (in step B) may have the opposite sign of charge from the (current at the) standard potential. Hereby a part of the deposited metal/metalloid may be reoxidised and optionally dissolved. Thus, such voltage/current should be such that - on average - reduction and deposition is larger the oxidation and dissolution.

In a method of the invention wherein current/potential is changed a plurality of times, the ratio of the absolute value of the current in step B to the absolute value of the current in step A is less than 1. Usually said ratio is less than 0.9. Preferably said ratio up to 0.8, in particular up to 0.6, more in particular up to 0.5.

The ratio of the current in step B to the current in step A (absolute values) is at least 0.

The current in step B may be an oxidising current (to redissolve part of the deposited metal or metalloid), as long as on average the amount of redissolved metal or metalloid is less than the amount of deposited metal or metalloid. It is also possible to change between a high reducing current and a low reducing current, wherein the low reducing current can be advantageous to allow growth of nuclei of the metal or metalloid.

The frequency of changing the potential/current can be chosen within wide limits. The frequency may be essentially constant or varied.

Usually, the average frequency of the changing (to get from a first reducing potential/current to the next reducing potential/current) is at least 0.01 Hz, in particular at least 0.1 Hz or at least 1 Hz. The average frequency of the changing is usually up to 10 KHz, in particular up to 1 KHz or up to 500 Hz.

The number of changes (the number of cycles from a step A to the next step A, or the number of cycles from a step B to the next step B) may be chosen within wide limits, depending upon factors, such as the desired amount of deposition (such as the desired layer thickness), the current density applied, the frequency, the deposition efficiency, the optional use of an etching potential/current. The skilled person will be able to determine a suitable number, based upon the information disclosed herein, common general knowledge and optionally some routine testing. In case a method is used wherein the current/potential is changed a plurality of times, the number of changes from A to B or B to A usually is more than 2, and in particular it may be at least 5, at least 10 or at least 25.

The upper limit is determined by reaching the target deposition (such as reaching a specific thickness of the electrode). It may for instance be up to 1000, up to 100 000 or up to 1 000 000. However a higher number of changes is in principle allowed, in particular in case the changing frequency is high.

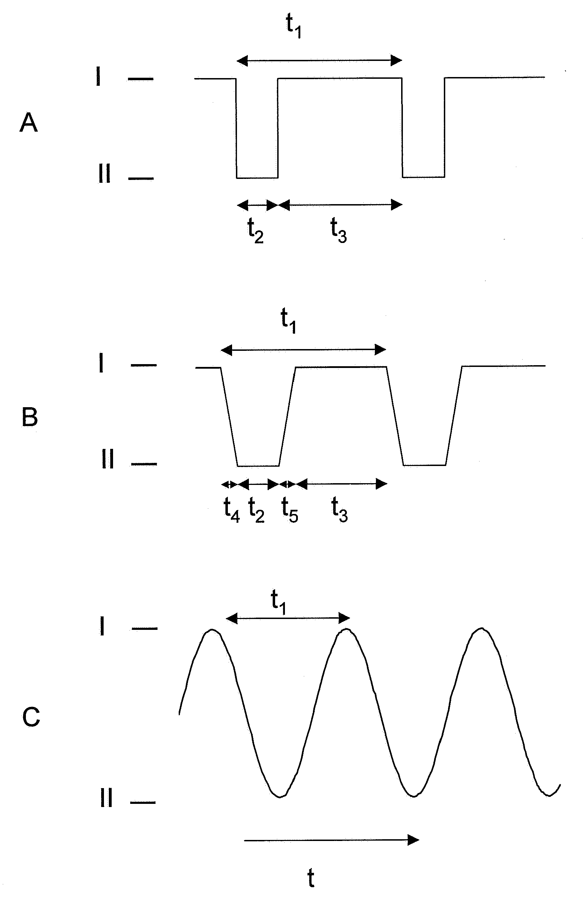

Figures 1A-C show a number of ways by which the current/potential can be changed. It will be understood that other possibilities may be employed, e.g. two or more of the ways of changing may be combined. Herein, Level II is a reduction current/potential at which deposition takes place. Level I can be a) a 0 current or rest potential (open circuit potential); b) an anodic current/potential at which a part of the previously deposited metal or metalloid may be (oxidised and) dissolved; c) a relatively low reduction current/potential (compared to Level II) which may be used to grow metal/metalloid nuclei, which are formed in a previous Level II current/potential. In these Figures, t₁ is the cycle time from a first Level I to the next (the reciprocal of the frequency), t₂ the duration of the current/potential at level II, t₃ the duration at level I, and t₄ respectively t₅ the time to change from (an extreme) current/potential from one level to the other, in case the current/voltage change is effected with a specific slope. The ratio of t₂/t₁ may be chosen within wide limits. A relatively high ratio may be advantageous from a processing time of view. The ratio t₂/t₁ may in particular be at least 0.001, at least 0.01, or at least 1. The ratio t₂/t₁ may in particular be up to 1000, up to 100 or up to 10.

In an embodiment of the invention, the changing comprises applying current/potential pulses, *e.g*. as shown in Figure 1A. Herein, the current/potential is changed essentially instantaneously.

In an embodiment, the change from a first current/potential to another takes places at a specific rate, *e.g.* as shown in Figure 1B.

In an embodiment, the changing comprises applying current/potential in an undulating way, for instance by a sinusoidal change, *e.g.* as shown in Figure 1C.

Further, the temperature may be controlled. Typically, the temperature is at least above the melting temperature of the ionic liquid / salt system. For practical reasons, the temperature is preferably at least ambient temperature, such as at least 20 °C or at least 25 °C. An elevated temperature, *e.g.* of at least 30 °C, at least 40 °C or at least 50 °C may be chosen in case a plating liquid to be used is not sufficiently liquid at ambient temperature. A relatively high temperature is usually advantageous for achieving a relatively low viscosity and/or a improved electrical conductance of the liquid.

Usually the temperature is up to 200 °C. For practical reasons, it may be preferred that the temperature is up to 100 °C, up to 70 °C or up to 50 °C, in particular in case a material upon which the metal or metalloid layer is deposited comprises a compound that is not sufficiently thermo-stable at a higher temperature.

Further, electro-deposition may be carried out with or without convection of the liquid, for instance with or without agitation. Convection is considered advantageous in order to avoid or at least reduce the occurrence of a possibly detrimental concentration gradient of the ions to be deposited at the cathode.

The plating liquid comprises an ionic liquid. An ionic liquid is a liquid formed of a salt that is liquid under the process conditions, such as a melt of a salt. In general an ionic liquid used in a method of the invention, has a melting point below 200 °C, preferably of 100 °C or less, in particular of 50 °C or less. It is in particular preferred that the ionic liquid is liquid at about 20 °C or at about 25 °C. Such liquid may be referred to as a room temperature liquid salt.

Salts that form an ionic liquid are known in the art. For instance, US-A 4,764,440 discloses a composition comprising a mixture of a metal halide and a hydrocarbyl-saturated onium salt, wherein at least one of the hydrocarbyl groups is an aromatic hydrocarbyl group. The contents of this publication with respect to the description of suitable ionic liquids, in particular as specified in the claims thereof is incorporated herein by reference. US-A 5,731,101 discloses an ionic liquid composition comprising a mixture of a metal halide and an alkyl-containing amine hydrohalide salt of the formula R₃ N.HX, where at least one R is alkyl and X is halogen, which amine hydrohalide salt contains either one or two alkyl groups therein. The contents of this publication with respect to the description of suitable ionic liquids, in particular as specified in the claims thereof is incorporated herein by reference.

US-A 5,892,124 discloses liquid salts of the general formula Q⁺A⁻, wherein Q⁺ represents quaternary ammonium or phosphonium, and A-represents various anions including tetrachloroaluminate and trichlorozincate. The contents of this publication with respect to the description of suitable ionic liquids, in particular as specified in the claims thereof is incorporated herein by reference.

In particular suitable is an ionic liquid selected from the ionic liquids described in WO 02/26381, of which the contents of this publication with respect to the description of suitable ionic liquids, in particular as specified in the claims thereof is incorporated herein by reference. Such ionic compound can be formed by the reaction of at least one amine salt of the formula R¹R²R³R⁴N⁺X⁻ (I) with at least one hydrated salt, which is a chloride, nitrate, sulphate or acetate of Li, Mg, Ca, Cr, Mn, Fe, Co, Ni, Cu, Zn, Cd, Pb, Bi, La or Ce; wherein R¹, R² and R³ are each independently a C₁ to C₅ alkyl or a C₆ to C₁₀ cycloalkyl group, or wherein R₂ and R₃ taken together represent a C₄ to C₁₀ alkylene group, thereby forming with the N atom of formula I a 5 to 11 membered heterocyclic ring, and wherein R⁴ is hydrogen, or phenyl, or a C₁ to C₁₂ alkyl or cycloalkyl group, optionally substituted with at least one group selected from OH, Cl, Br, F, I, phenyl, NH₂, CN, NO₂, COOR5, CHO, COR⁵ and OR⁵, wherein R⁵ is a C₁ to C₁₀ alkyl or cycloalkyl group, and X- is an anion capable of being complexed by the said hydrated salt, for instance a halogen ion, such as Cl- or Br⁻.

In an embodiment, the ionic liquid comprises a salt of the following cations and/or anions:
- cations selected from the group of monosubstitued imidazolium compounds, disubstituted imidazolium compounds, trissubstitued imidazolium compounds, pyridinium compounds, pyrrolidinium compounds, phosphonium compounds, ammonium compounds, guanidinium compounds and isouronium compounds, including combinations thereof. The substituents may in particular be selected from the substituents described above, when referring to R¹-R⁵ in the amine salt of the formula R¹R²R³R⁴N⁺X⁻ (I).
- anions selected from the group of chloride, bromide, iodide, nitrate, nitrite, fluoride, phosphate, imide, amide, borate, tosylate, tetrafluoroborate, hexafluoroborate, hexafluorophosphate, trifluoromethanesulfonate, methylsulfate, bis(pentafluoroethyl)phosphinate, thiocynate, octylsulfate, hexylsulfate, buthylsulfate, ethylsulfate, dicyanamide, hexafluoroantimonate, bis-(pentafluoroethyl)phospinate, bis-(trifluoromethyl)imide, trifluoroacetate, bis-trifluorsulfonimide, triflate and dicyanamide, including combinations thereof.

The plating liquid may comprise a solvent, solvents being materials other than the liquid salt which are liquid under the conditions at which the method is carried out. In particular, the solvent may be chosen from inorganic solvents other than water and organic solvents, such as benzene or an alcohol.

The solvent concentration will usually be less than 25 wt. %, based on total liquid salt, in particular 20 wt. % or less, more in particular 15 wt. % or less. Preferably, the solvent concentration is up to 2 wt. % based on total liquid salt, more preferably less than 1 wt. %.

In general it is preferred that the plating liquid is essentially free of water and/or other solvents. A plating liquid is in particular considered to be essentially free of a solvent if the concentration of that solvent is less than 0.5 wt. %, based on total liquid salt, more in particular less than O.lwt. % of a solvent, or less than 0.01 wt. %.

A maximum desired water level (in view of efficiency and/or effectivity) depends on the metal to be deposited. In case the standard potential is higher than the standard potential of water to hydrogen (*e.g.* Ag, Au, Cu), then the water concentration is preferably 0.1 wt. % or less. In particular, in case the standard potential is equal to or less than the standard potential of water to hydrogen (*e.g.* Al, Ba, Li) then a water content of less than 10 ppm, in particular of 1 ppm or less is desired.

The ions to be deposited may be all ions of the same metal or metalloid. It is also possible to deposit ions from different metals/metalloids. In particular, ions to be deposited may be selected from metals or metalloids which form a dense oxide. In particular the oxide should have a low permeability to oxygen and/or water, such that it protects the metal covered by the oxide layer against corrosion. Metals of which the oxide forms a dense layer are also known in the art as valve metals.

A metallic layer as used herein is an layer comprising one or more metals, thus the term includes layers of a metallic alloy. In particular a layer is considered metallic if it shows metallic electrical conductance.

Metalloids are elements that are generally not considered real metals, but that do show more or less metallic behaviour in one or more specific aspects. In particular, metalloids are capable of conducting electricity, to the extent that they are semiconductors rather than metallic conductors. In particular, Boron (B), Silicon (Si), Germanium (Ge), Arsenic (As), Antimony (Sb), Tellurium (Te) and Polonium (Po) are examples of metalloids.

A metalloid layer as used herein is a layer comprising one or more metalloids, thus the term includes layers comprising a metalloid alloy. In particular a layer is considered a metalloid layer if it shows metalloid electrical conductance (i.e. showing semi-conductive properties, such as a semi-metal).

Preferably one or more ions selected from the group of aluminium, silicon, tantalum, titanium, chromium, bismuth, zirconium, hafnium, tungsten, niobum and zinc, may be reduced and deposited in accordance with the invention, to form a barrier layer, optionally after at least partial oxidation.

The counter ions of the metal ions or metalloid ions used for deposition may be the same or different from the cations of the ionic liquid. In particular the counter ions may be chosen from the group of chloride, bromide, iodide, nitrate, nitrite, fluoride, phosphate, imide, amide, borate, tosylate, tetrafluoroborate, hexafluoroborate, hexafluorophosphate, trifluoromethanesulfonate, methylsulfate, bis(pentafluoroethyl)phosphinate, thiocynate, octylsulfate, hexylsulfate, buthylsulfate, ethylsulfate, dicyanamide, hexafluoroantimonate, bis-(pentafluoroethyl)phospinate, bis-(trifluoromethyl)imide, trifluoroacetate, bis-trifluorsulfonimide, triflate and dicyanamide, including combinations thereof.

In an embodiment of the invention, a layer of an alloy is formed by using co-deposition, This may be achieved by using a single plating liquid comprising more than one type of ions to be deposited on the substrate, to allow co-deposition to take place in a single electro-deposition process.

In an embodiment, the different ions to be deposited are dissolved in separate plating liquids, with which the substrate is sequentially contacted under plating conditions. This allows the formation of different layers on top of each other.

The total concentration of the salt comprising the ions for forming the electrode preferably is at least 0,1 mol%, more preferably at least 1 mol%, even more preferably at least 5 mol%, or at least 10 mol%. A relatively high concentration is in particular advantageous in order to allow a high deposition speed.

The upper limit is in particular determined by the maximum allowable concentration in order to maintain the plating liquid in a liquid state (the saturation level). A relatively high concentration usually advantageous for a high deposition rate. Also a large amount of ions can usually be reduced and deposited before depletion of the liquid may become noticeable. Also the presence of the ions to be deposited in a relatively high concentration may be advantageous for improved liquidity (reduced viscosity, reduced melting temperature of the liquid), and/or improved electrical conductance of the liquid.

The total concentration of the salt of the metal/metalloid ions for forming the layer by electro-deposition preferably is up 70 mol %, more preferably up to 65 mol %, in particular up to 60 mol%. For practical reasons, e.g. reaching saturation in the liquid, a lower concentration may be chosen, e.g. up to 40 mol %, up to 20 mol %, up to 10 mol %, or 5 mol % or less.

In an advantageous embodiment, a "sacrificial electrode" is used as a counter electrode (anode). At least the surface of such an electrode comprises the same metal or metalloid as the metal or metalloid that is to be deposited. While the metal or metalloid is deposited on the substrate during electro-deposition, metal/metalloid at a surface of the sacrificial electrode will be oxidised and dissolve in the plating liquid. Thus, the composition of the plating liquid can be maintained at about the same concentration for a prolonged timed, or at least depletion of the liquid with metal/metalloid ions can be postponed. Such electrode may for instance be a plate, foil or thread of the metal/metalloid to be deposited, *e.g*. an aluminium counter electrode can be used when depositing aluminium on a substrate form a aluminium ions containing ionic liquid electrolyte.

The plating liquid may further comprise one or more additives, such as a brightener (*e.g*. for helping to obtain a smooth surface) and/or a surface active agent (*e.g.* for improved adherence). One or more additives are optionally also deposited. Suitable conditions for the additives are *e.g.* described in "Effect of additives", Chapter 10 in M. Schlesinger, M. Paunovic (eds), "Fundamentals of Electrochemical Deposition", Electrochemical Society Series, 2nd Edition, 2006, John Wiley & Sons, New York, of which Chapter the contents are incorporated by reference.

The invention allows the formation of a layer with satisfactory properties within a wide thickness range. A desired thickness *e.g.* may be determined based on considerations such as the desired barrier properties, transparency (which may or may not be desired), flexibility of the article (which may or may not be desired), etc.

The thickness may in particular be at least 1 nm, at least 10 nm, at least 100 nm, at least 1 µm, at least 10 µm or at least 100 µm. The thickness may in particular be up to 1 mm, up to 400 µm, up to 100 µm, up to 10 µm, up to 1 µm up to 100 nm or up to 10 nm.

After forming the layer, the device may be subjected to one or more post-treatment steps. For instance, excess ionic liquid may be removed. One or more further steps, such as the provision of one or more other functional layers, which may be employed are, *e.g.* described in the prior art identified herein.

The deposited metal or metalloid is preferably at least partially oxidised, to form a metal oxide or metalloid oxide barrier layer. Suitable oxidation techniques include thermal oxidation and chemical oxidation, in particular electrochemical oxidation.

(Electro)chemical oxidation may for instance be accomplished by oxidation in an aqueous liquid (usually comprising more than 50 wt. % water, based on total liquids, and an electrolyte to impart conductivity to the liquid. The skilled person will know how to choose suitable conditions, such as a suitable pH, temperature and reagents, depending upon the metal or metalloid to be oxidised. For instance, for aluminium a pH at or near neutral pH (neutral pH ± 1 pH) is considered particularly suitable. Preferably, the oxidation is carried out in the presence of a pH modulator, in particular a (weak) acid or base, more in particular an acid and a base forming a pH-buffer.

Thermal oxidation may be accomplished by heating the layer in the presence of oxygen or a gas comprising oxygen, *e.g*. air.

Advantageously, a plurality (at least two) of layers selected from the group of metallic layers, metalloid layer, metal oxide layers and metalloid oxide layers is applied. Preferably an intermediate layer is applied in between two subsequent layers. Such layer may in particular serve to decouple pinholes (which may still be present to a limited extent) in the metal/metalloid/metal oxide/metalloid oxide layer and/or to planarise such layer. Such layer may improve resiliency of the barrier layer, resistance against cracking, and/or resistance against delamination. In case use is made of a flexible material (preferably an elastic material) for such intermediate layer, such layer may improve flexibility of the barrier layer as a whole.

Such intermediate layer may in particular be an organic layer as described in WO 2005/015655, WO 03/094256 or US 2003/0203210, of which the contents with respect to these layers are incorporated by reference.

Suitably such layer may comprise a polymer, in particular a polymer selected from acrylate polymers, epoxy polymers, fluoropolymers, poly p-xylene (ppx) and organosilicones. The intermediate layer may in particular be applied as a liquid comprising an organic compound, *e.g.,* by spin coating, spray coating, immersion, condensation, printing (*e.g*. inkjet, screen, gravure, flexo), wedge coating kiss coating, slot dye coating.

Optionally, a metal/metalloid layer is first at least partially oxidised, then the intermediate layer is applied, and then a subsequent metal/metalloid layer is deposited. In particular in case the intermediate layer is relatively thin, electrons may leak through the layer, also if the layer is made of an electrically insulating material, thus allowing further electro-deposition without pretreatment of the surface of the intermediate layer. Alternatively, a conductive seed layer may be applied to the surface of the intermediate layer prior to further electrodeposition.

The procedure of applying metal/metalloid, optionally oxidising, and applying an intermediate layer may then be repeated as often as desired to obtain a desired stack of layers.

The thickness of an intermediate layer can be chosen within a wide range, in particular it can be up to 10 µm, up to 1 µm or up to 500 nm. Usually, if present, the thickness is at least 50 nm, in particular at least 100 nm. For an inorganic intermediate layer a thickness of 50-200 nm is particularly suitable; for an organic (such as a organic polymeric) intermediate layer a layer of 500 nm to 10 µm is particularly suitable.

Optionally a top layer is applied over the outermost metallic, metalloid, metal oxide or metalloid oxide layer. Such layer may be applied from a material as described above for the intermediate layer, in a manner as described above for the intermediate layer and/or have a thickness as described above for the intermediate layer.

## Claims

1. Method for manufacturing an article comprising a barrier layer, the method comprising
- providing an metallic or metalloid layer to a surface of a substrate by electro-deposition, using a plating liquid comprising an ionic liquid and metal ions or metalloid ions, which metal ions or metalloid ions are reduced and deposited to form the metallic or metalloid layer during the electro-deposition; and
- preferably at least partially oxidising the metallic or metalloid layer.

2. Method according to claim 1, wherein the metallic or metalloid layer is electro-deposited using a roll-to-roll technique.

3. Method according to claim 1 or 2, wherein the metal ions or metalloid ions are selected from the group of aluminium, silicon, tantalum, titanium, chromium, bismuth, zirconium, hafnium, tungsten, niobum, zinc

4. Method according to any of the preceding claims, wherein a stack comprising a plurality of metallic, metalloid oxidised metallic or oxidised metalloid layers is provided, wherein at least two of said layers are separated by an intermediate layer.

5. Method according to any of the preceding claims, wherein the ionic liquid comprises a salt, liquid under the process conditions, selected from salts formed of
- at least one of the cations from the group of monosubstitued imidazolium derivates, disubstituted imidazolium derivates, trissubstitued imidazolium derivates, pyridinium derivates, pyrrolidinium derivates, phosphonium derivates, ammonium derivates, guanidinium derivates and isouronium derivates.
- and at least one of the anions from the group of chloride, bromide, iodide, nitrate, nitrite, fluoride, phosphate, imide, amide, borate, tosylate, tetrafluoroborate, hexafluoroborate, hexafluorophosphate, trifluoromethanesulfonate, methylsulfate, bis(pentafluoroethyl)phosphinate, thiocynate, octylsulfate, hexylsulfate, buthylsulfate, ethylsulfate, dicyanamide, hexafluoroantimonate, bis-(pentafluoroethyl)phospinate, bis-(trifluoromethyl)imide, trifluoroacetate, bis-trifluorsulfonimide, triflate and dicyanamide.

6. Method according to any of the preceding claims, wherein the ionic liquid comprises a salt, liquid under the process conditions, selected from salts formed by the reaction of at least one amine salt of the formula R¹R²R³R⁴N⁺X⁻ (I) with at least one hydrated salt, which is a chloride, nitrate, sulphate or acetate of Li, Mg, Ca, Cr, Mn, Fe, Co, Ni, Cu, Zn, Cd, Pb, Bi, La or Ce; wherein R¹, R² and R3 are each independently a C₁ to C₅ alkyl or a C₆ to C₁₀ cycloalkyl group, or wherein R₂ and R₃ taken together represent a C₄ to C₁₀ alkylene group, thereby forming with the N atom of formula I a 5 to 11 membered heterocyclic ring, and wherein R⁴ is hydrogen, or phenyl, or a C₁ to C₁₂ alkyl or cycloalkyl group, optionally substituted with at least one group selected from OH, Cl, Br, F, I, phenyl, NH₂, CN, NO₂, COOR⁵, CHO, COR⁵ and OR⁵, wherein R⁵ is a C₁ to C₁₀ alkyl or cycloalkyl group, and X- is an anion capable of being complexed by the said hydrated salt.

7. Method according to any of the preceding claims, wherein the electrical potential and/or electrical current are changed a plurality of times between at least one first value (A) and at least one second value different from said first value (B), at least one of said values being sufficient to cause the deposition.

8. Method according to any of the preceding claims, wherein the electro-deposition is current controlled.

9. Method according to any of the preceding claims, wherein the plating liquid is essentially water-free.

10. Method according to any of the preceding claims, wherein the metallic or metalloid layer is deposited on a substrate comprising an organic electro-active material.

11. Method according to any of the preceding claims, wherein the substrate is selected from the group of foils, films and sheets.

12. Method according to any of the preceding claims, wherein the metallic or metalloid layer is at least partially oxidised by thermal oxidation or electrochemical oxidation.

13. Method according to any of the preceding claims, wherein the metal or metalloid layer is oxidized to form a metal oxide or a metalloid oxide layer.

14. Method according to any of the preceding claims,wherein the article is selected from the group of organic diodes, such as organic LED's, organic photo-voltaic cells; organic actuators for converting mechanical energy to electrical energy or vice versa; organic electrical circuits, organic transistors, organic solar cells; steel sheets; and packaging foils, such as aluminium packaging foils or plastic packaging foils.

15. Article obtainable by a method according to any of the preceding claims.

16. Article according to claim 15, wherein the permeability for water is less than 10⁻³ g water/m²/day, preferably less than 10⁻⁵ water/m²/day.
